Europäisches Patentamt

European Patent Office

Office européen des brevets

(19)

(11) Veröffentlichungsnummer: **0 344 654**
**A2**

## EUROPÄISCHE PATENTANMELDUNG

(21) Anmeldenummer: **89109582.0**

(22) Anmeldetag: **27.05.89**

(51) Int. Cl.⁴: **G01R 1/073**

(30) Priorität: **01.06.88 DE 3818686**

(43) Veröffentlichungstag der Anmeldung:
**06.12.89 Patentblatt 89/49**

(84) Benannte Vertragsstaaten:
**AT CH DE FR GB IT LI NL SE**

(71) Anmelder: **Prokopp, Manfred**
**Am Felder 27**
**D-6980 Wertheim-Reicholzheim(DE)**

(72) Erfinder: **Prokopp, Manfred**
**Am Felder 27**
**D-6980 Wertheim-Reicholzheim(DE)**

(74) Vertreter: **König, Oskar, Dr. Dipl.-Phys.**
**Postfach 10 27 33**
**D-7000 Stuttgart 10(DE)**

(54) **Verfahren und Prüfadapter zum Kontaktieren von Prüflingen.**

(57) Verfahren zum Kontaktieren von Prüflingen mittels Kontaktnadeln (11). Diese sind in einem Prüfadapter (10) angeordnet, wo sie in einer Frontplatte (13) geradegeführt sind und Löcher einer Spannplatte (14) durchdringen, die die Kontaktnadeln (11) aus ihren geraden Stellungen ausbiegen kann. Die Kontaktnadeln (11) üben auf den Prüfling dadurch ansteigende Kräfte aus, indem die Spannplatte (14) in einer Bewegungsrichtung bewegt wird, die zu der dem Spannen der Kontaktnadeln (11) dienenden Bewegungsrichtung entgegengesetzt ist.

FIG.1

EP 0 344 654 A2

## Verfahren und Prüfadapter zum Kontaktieren von Prüflingen

Die Erfindung betrifft ein Verfahren zum Kontaktieren von elektrischen oder elektronischen Prüflingen gemäß dem Oberbegriff des Anspruches 1 und einen Prüfadapter zur Durchführung dieses Verfahrens.

Bei durch solche Prüfadapter zu kontaktierenden Prüflingen kann es sich insbesondere um Leiterplatten, Chips, integrierte Schaltkreise, Verdrahtungen aufweisende Prüflinge oder dgl. handeln.

Es ist ein Prüfadapter bekannt (DE-OS 31 23 627), bei welchem zum gleichzeitigen Kontaktieren von mehreren Prüfpunkten eines Prüflings aus federelastischem Metall bestehende Kontaktnadeln vorgesehen sind, die in einem Gestell geführt sind. Die in axialer Richtung wirkende Federkraft jeder solchen Kontaktnadel wird durch Ausbiegen senkrecht zu ihrer Längsrichtung beim Aufsetzen auf den Prüfling dadurch aufgebracht, indem der Prüfling die auf ihn aufgesetzten vorderen Enden der Kontaktnadeln aufwärts auf eine von den Kontaktnadeln mit mittleren Bereichen durchdrungene Spannplatte zu bewegt, wodurch die Kontaktnadeln sich weiter seitlich ausbiegen. Dabei liegt die Spannplatte in der Ruhestellung, wenn die Kontaktnadeln keinen Prüfling kontaktieren, an einem Anschlag an, der so angeordnet ist, daß die Kontaktnadeln durch die Spannplatte bereits etwas seitlich ausgebogen sind, bevor der jeweilige Prüfling sie zum Aufbringen der erforderlichen, relativ grossen Kontaktkräfte noch weiter ausbiegt. Wenn die vorderen Enden der Kontaktnadeln auf diese Weise durch einen Prüfling in Richtung auf die Frontplatte zu, in der sie in der Nähe ihrer vorderen Enden axial geradgeführt sind, bewegt werden, dann wird also hierdurch die seitliche Ausbiegung der Kontaktnadeln vergrößert und die Kontaktnadeln bewegen dann hierdurch die Spannplatte unter Abheben von ihrem Anschlag seitlich weg. Wenn der Prüfling entfernt wird, kehren die Kontaktnadeln wieder in ihre Ausgangsstellung zurück, in der die Spannplatte wieder an dem Anschlag anliegt.

Die Kräfte, die solche Kontaktnadeln auf den jeweiligen Prüfling ausüben müssen, sind relativ groß, da sicherer elektrischer Kontakt zwischen diesen Kontaktnadeln und den kontaktierten Stellen des Prüflinges erforderlich ist, wozu erforderlichenfalls die Kontaktnadeln auch Oxidschichten oder Schmutzschichten auf dem Prüfling durchstoßen müssen. Ein solcher Prüfadapter hat im allgemeinen eine große Anzahl solcher Kontaktnadeln, meist mehrere hundert bis oft viele tausend. Es müssen deshalb beim Kontaktieren des jeweiligen Prüflings für die Relativbewegung zwischen Prüfadapter und Prüfling, die dem axialen Verschieben der vorderen Enden der Kontaktnadeln durch den Prüfling in Richtung auf die Frontplatte zu dient, oft außerordentlich große Kräfte auf den Prüfadapter bzw. den Prüfling durch einen entsprechend stark dimensionierten motorischen Antrieb aufgebracht werden. Dies ist baulich kostenaufwendig und verursacht auch relativ hohe Betriebskosten.

Es ist deshalb eine Aufgabe der Erfindung, ein Verfahren der im Oberbegriff des Anspruches 1 genannten Art zu schaffen, das sich mit viel geringeren Kräften durchführen läßt.

Diese Aufgabe wird erfindungsgemäß durch das in Anspruch 1 angegebene Verfahren· gelöst. Ein erfindungsgemäßer Prüfadapter zur Durchführung dieses Verfahrens ist in Anspruch 6 beschrieben.

Die Erfindung nutzt den Effekt aus, daß das seitliche Ausbiegen der Kontaktnadeln durch Bewegen der Spannplatte in der ersten Bewegungsrichtung viel geringere Kräfte erfordert als das seitliche Ausbiegen der Kontaktnadeln durch axiales Bewegen ihrer freien vorderen Enden durch den jeweiligen Prüfling. Demzufolge ist der Arbeits- und Kraftaufwand zum Prüfen von Prüflingen bei dem erfindungsgemäßen Verfahren viel geringer als bei dem vorbekannten Prüfadapter. Auch ermöglicht die Erfindung das Kontaktieren der Prüflinge je nach Wunsch schonend unter langsamem oder unter schnellem, ggf. schlagartigem Auftreffen der Kontaktnadeln auf den Prüfling durchzuführen. Besonders schonend kann das Verfahren dadurch durchgeführt werden, indem man den zu kontaktierenden Prüfling in geringem Abstand vor den freien Enden der durch die Spannplatte voll gespannten, d.h. in ihre am weitesten ausgebogene Gestalt gebogenen Kontaktnadeln bringt oder an diese vorderen Enden ohne oder mit geringer Kraft anlegt und dann die Spannplatte langsam in der die Ausbiegung der Kontaktnadeln verringernden zweiten Bewegungsrichtung vorzugsweise motorisch oder ggf. auch von Hand bewegt. Es findet dann keine schlagartige Beanspruchung des Prüflings statt. Wenn man dagegen auch in besonders schwierigen Fällen und auch ggf. mit relativ kleinen, von den Kontaktnadeln auf den Prüfling ausgeübten Kräften besonders sichere elektrische Kontakte zwischen den Kontaktnadeln und dem jeweiligen Prüfling herstellen will, dann kann man so vorgehen, daß man den Prüfling in geringem Abstand von den freien Enden der Kontaktnadeln bringt und dann die Spannplatte, die die Kontaktnadeln ausgebogen hält, schlagartig freigibt oder schnell motorisch oder auf sonstige Weise in der zweiten Bewegungsrichtung bewegt, so daß die Kontaktnadeln dann entsprechend schnell auf die von ihnen kontaktierten Stellen des Prüflinges hierdurch besonders sicher Oxidschichten und Schmutzschichten durchschlagend auftreffen. Dies kann man auch dadurch unterstützen, indem die Spannplatte in ihrer zweiten Bewegungsrichtung nicht nur in eine Stellung bewegt wird, in der sie die Kontaktnadeln nicht mehr belastet, sondern sie vorzugsweise motorisch - bspw. mittels eines Federmotors - in der zweiten Bewegungsrichtung zwangsweise über diesen Stellungsbereich hinaus noch weiterbewegt wird, um die Kontaktnadeln dann in der zweiten Bewegungsrichtung weiter zu biegen, wodurch die auf den jeweiligen Prüfling durch die Kontaktnadeln axial ausgeübten Kräfte noch weiter erhöht werden, d.h. über die durch die Eigenelastizität der Kontaktnadeln ausübbaren axialen Kräfte hinaus noch erhöht werden. Andererseits ist es auch möglich, wenn man die von den Kontaktnadeln auf einen Prüfling ausgeübten Kräfte bspw. wegen hoher Empfindlichkeit des Prüflinges unter die Kräfte verringern will, die die Kontaktnadeln ausüben würden, wenn auf sie von der Spannplatte beim Kontaktieren eines Prüflinges keine Kräfte mehr ausgeübt würden, kann man dies dadurch erreichen, indem man die Spannplatte in der zweiten Bewegungsrichtung sich nur so weit bewegen läßt, sei es durch motorische Verstellung oder durch Inanschlagkommen an einen vorbestimmten Anschlag, daß die durch die Eigenelastizität der Kontaktnadeln bewirkbaren axialen Kontaktkräfte nicht erreicht werden. In diesen Stellungen der Kontaktnadeln liegen sie dann noch an der Spannplatte mit Vorspannung an, wobei sich die Spannplatte in einer Zwischenstellung befindet zwischen der durch Bewegen in der ersten Bewegungsrichtung erreichten, dem vollen Spannen der Kontaktnadeln dienenden Stellung und der Stellung, die sie einnehmen würde, wenn sie auf die Kontaktnadeln keine Kräfte mehr ausüben würde.

Bei der Erfindung ist es möglich, daß die freien Enden der Kontaktnadeln in deren voll gespanntem Zustand nicht über die Frontplatte überstehen. Es ist jedoch auch möglich, die Frontplatte so anzuordnen, daß die freien Enden der Kontaktnadeln, wenn die Kontaktnadeln mittels der Spannplatte voll gespannt sind, über die Frontplatte überstehen. Im ersteren Falle kann man auch vorsehen, zum Kontaktieren eines Prüflings zunächst den Prüfling an diese Frontplatte direkt anzulegen, da die Kontaktnadeln über sie nicht überstehen, und dann die Spannplatte in der die Ausbiegung der Kontaktnadeln verringernden zweiten Bewegungsrichtung motorisch oder durch ein Bedienungsorgan zu bewegen bzw. durch die Elastizität der Kontaktnadeln selbst bewegen zu lassen.

Da die Kräfte zum Spannen der Kontaktnadeln relativ gering sind, kann man in vielen Fällen zweckmäßig vorsehen, daß die Spannplatte durch eine Bedienungsperson von Hand oder mittels des Fußes gespannt wird, wobei das betreffende, von Hand oder Fuß betätigte Betätigungsorgan über ein kraftminderndes Getriebe mit der Spannplatte gekoppelt sein kann. Es ist jedoch auch möglich und im allgemeinen besonders zweckmäßig, vorzusehen, daß die Spannplatte mittels mindestens eines Stellmotors bewegt wird, wobei der mindestens eine Stellmotor nur dem Bewegen der Spannplatte zum Spannen der Kontaktnadeln oder sowohl zum Spannen der Kontaktnadeln als auch zum Bewegen der Spannplatte in der die Ausbiegung der Kontaktnadeln verringernden zweiten Bewegungsrichtung dienen kann, oder für das letztere Bewegen der Spannplatte kann auch mindestens ein anderer Stellmotor vorgesehen sein.

Die Kontaktnadeln können zweckmäßig aus besonders gutem federelastischen Metall bestehen, wie Federstahl, federelastischem Kupfer-Beryllium oder dgl.

In der Zeichnung sind Ausführungsbeispiele der Erfindung dargestellt. Es zeigen:

Fig. 1 in geschnittener und teilweise schematischer Darstellung einen Prüfadapter gemäß einem Ausführungsbeispiel der Erfindung,

Fig. 2 bis 4 unterschiedliche Möglichkeiten des Betriebs des Prüfadapters nach Fig. 1 bezüglich unterschiedlichen Endstellungen der Spannplatte des Prüfadapters, bei denen die Kontaktnadeln, von denen hier jeweils nur eine dargestellt ist, einen Prüfling für die Durchführung seiner elektrischen Prüfung auf Fehlerfreiheit kontaktieren.

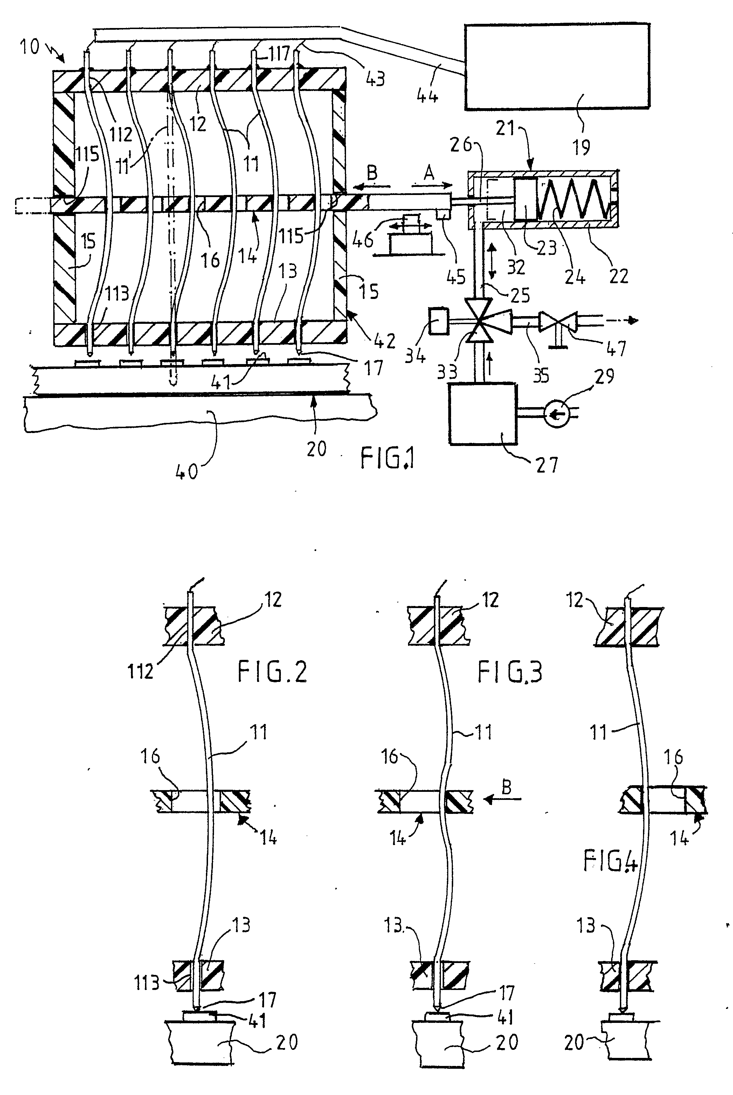

Der in Fig. 1 geschnitten dargestellte Prüfadapter 10 weist eine Vielzahl von in ungespanntem Zustand geraden Kontaktnadeln 11 auf, wie es für eine der Kontaktnadeln 11 bei 11' dargestellt ist. Diese Kontaktnadeln bestehen aus elastisch federndem Metall, wie Stahl, federndem Kupfer-Beryllium oder dgl. und sind einstückig. Sie weisen über ihre Länge mit Ausnahme ihrer konischen Spitzen in ungespanntem Zustand kreiszylindrische Gestalt auf und können sehr kleine Durchmesser von bspw. 0,1 bis 0,8 mm aufweisen, ggf. jedoch auch noch kleinere oder größere Durchmesser.

Diese Kontaktnadeln 11 dienen dem Kontaktieren eines jeweiligen, auf einer Halteplatte oder Aufspannplatte 40 aufgespannten Prüflinges 20, der in diesem Ausführungsbeispiel ein Chip ist, welcher Kontaktflächen(Pads) 41 aufweist, welche zur elektrischen Prüfung dieses Prüflinges 20 auf Fehlerfreiheit durch die Kontaktnadeln 11 gleichzeitig mit ausreichend hoher axialer Kontaktkraft zu kontaktieren sind, um gute elektrische Verbindungen dieser Kontaktnadeln 11 mit diesen Pads 41 herzustellen. Wenn der Prüfling 20 eine andere Bauart hat, bspw. eine bestückte oder unbestückte Leiterplatte ist, dann können die Kontaktnadeln 11 auch dem Kontaktieren von anderen Stellen als Pads dienen, wie Leiterbahnen, Füßen von elektrischen Komponenten., Bohrungsrändern, Lötstellen oder dgl.

Die Kontaktnadeln 11 sind an rückwärtigen Endbereichen in zueinander parallelen Löchern oder Bohrungen 112 einer rückwärtigen Platte 12 eines Gestells 42 des Prüfadapters 10 befestigt, über welche Bohrungen 112 sie nach rückwärts noch etwas überstehen, und hier sind an ihre rückwärtigen Enden 117 elektrische Leiter 43 angeschlossen, die zu einem Kabel 44 zusammengefaßt und gegeneinander elektrisch isoliert zu einem Testgerät 19 geführt sind. Sobald ein zu prüfender Prüfling 20 durch die Kontaktnadeln 11 mit den vorgesehenen Kontaktkräften kontaktiert ist, dann führt das Testgerät 19 die elektrische Prüfung des Prüflinges auf Fehlerfreiheit durch, wobei die Kontaktnadeln 11 und die an sie angeschlossenen Leiter 43 die Pads 41 an das Testgerät 19 elektrisch anschließen.

Die rückwärtige Platte 12 ist zur vorderen Frontplatte 13 parallel, wobei diese beiden Platten 12 und 13 mittels Seitenplatten 15 fest miteinander verbunden sind. Die Platten 12 und 13 bestehen aus elektrisch isolierendem Material, wie Kunststoff, Keramik oder dgl., um hierdurch die Kontaktnadeln 11 gegeneinander elektrisch zu isolieren.

In der Frontplatte 13 ist für jede Kontaktnadel 11 ein gerades kreiszylindrisches Loch 113 gebohrt, welche Löcher 113 zueinander parallel und von den Kontaktnadeln 11 mit Gleitlagerspiel durchdrungen sind, so daß die Kontaktnadeln 11 in der Nähe ihrer vorderen Enden 17 in dieser Frontplatte 13 axial gleitbar geradegeführt sind.

Die Kontaktnadeln 11 durchdringen ferner mit mittleren Bereichen zueinander parallele Löcher 16 einer Spannplatte 14. Diese Spannplatte 14 ist in Durchbrüchen 115 der Seitenplatten 15 geradegeführt mit Gleitlagerspiel gelagert und parallel zu den Platten 12 und 13. Die von den Kontaktnadeln 11 durchdrungenen Löcher 16 dieser Spannplatte 14 haben in Richtung parallel zur Ebene der Spannplatte 14 erheblich größere Breite als dem Durchmesser der Kontaktnadeln 11 im Bereich dieser Löcher 16 entspricht. Diese Breite kann vorzugsweise mindestens dem 1,5-fachen Durchmesser der Kontaktnadeln, besonders zweckmäßig mindestens dem 3-fachen Durchmesser der Kontaktnadeln entsprechen oder noch größer sein, wie es in diesem Ausführungsbeispiel der Fall ist. Diese Löcher 16 können kreisrunde Löcher oder Langlöcher sein. In letzterem Falle kann dann ihre lichte Breite senkrecht zur Bildebene mit Gleitlagerspiel größer als die Durchmesser der sie durchdringenden Bereiche der Kontaktnadeln 11 sein.

Die Spannplatte 14 ist in einer dem vollen oder maximalen Spannen der Kontaktnadeln 11 dienenden ersten Bewegungsrichtung (Pfeil A) mittels eines Stellmotores 21 bewegbar. Dieser Stellmotor 21 ist in diesem Ausführungsbeispiel eine pneumatische oder hydraulische Kolben-Zylinder-Einheit mit durch eine Rückstellfeder 24 belastetem Kolben 23, kann jedoch auch andere geeignete Ausbildung haben, bspw. ein Elektromotor oder ein Hubmagnet oder von sonstiger geeigneter Bauart sein.

Diese einen Arbeitszylinder und infolge der Feder 24 auch einen Federmotor bildende Kolben-Zylinder-Einheit 21 weist einen Zylinder 22 auf, in welchem der Kolben 23 axial gleitbar angeordnet ist. Die Kolbenstange 26 ist mit der Spannplatte 14 bewegungsschlüssig, vorzugsweise fest verbunden. Der linksseitig des Kolbens 23 befindliche Arbeitsraum 32 des Zylinders 22 ist über eine Leitung 25 und ein Drei-Wege-Ventil 33 an einen Druckspeicher 27 angeschlossen, in den flüssiges oder gasförmiges Druckmedium mittels einer Pumpe 29 förderbar ist und in welchem ein konstanter Druck durch Regeln aufrechterhalten werden kann. Das Ventil 33 ist mittels eines Stellgliedes 34 motorisch so verstellbar, daß der Arbeitsraum 32 des Zylinders wahlweise mit dem Druckspeicher 27 oder mit einer dem Ableiten von Druckmedium aus diesem Arbeitsraum 32 dienenden Abflußleitung 35 verbindbar ist.

Während das in diesen Arbeitsraum 32 aus dem Druckspeicher 27 einleitbare Druckmedium dem Bewegen des Kolbens 23 in Richtung des Pfeiles A, d.h. dem Bewegen der Spannplatte 14 in ihrer ersten Bewegungsrichtung zum vollen Spannen der Kontaktnadeln dient, wobei unter vollem Spannen ihr seitliches Ausbiegen in ihre am weitesten in Richtung des Pfeiles A ausgebogenen Stellungen oder Gestalten verstanden ist, dient die Feder 24 dem Bewegen des Kolbens 20 nach links, d.h. dem Bewegen der Spannplatte 14 in ihrer zweiten Bewegungsrichtung (Pfeil B), die entgegengesetzt zu der ersten Bewegungsrichtung (Pfeil A) ist. Diese Bewegung in der zweiten Bewegungsrichtung wird teilweise noch durch die Eigenelastizität der durch die Spannplatte 14 ausgebogenen Kontaktnadeln 11 unterstützt. Bewegen der Spannplatte 14 in dieser zweiten Bewegungsrichtung findet dann statt, wenn nach dem durch Einleiten von Druckmedium in den Arbeitsraum 32 durch Bewegen der Spannplatte 14 in der ersten Bewegungsrichtung erfolgendem vollen Spannen der Kontaktnadeln 11 das Drei-Wege-Ventil 33 mittels des Stellgliedes 34 so umgeschaltet wird, daß es nunmehr den Arbeitsraum 32 vom Druckspeicher 27 abschaltet und diesen Arbeitsraum mit der Abflußleitung 35 verbindet, so daß das Druckmedium aus dem Arbeitsraum 32 abfließen kann und der Kolben 23 und damit die Spannplatte 14 sich nunmehr in der zweiten Bewegungsrichtung nach links bewegen können.

Es ist auch in vielen Fällen möglich, die Feder 24 wegzulassen, und zwar dann, wenn vorgesehen ist, die Spannplatte 14 in der zweiten Bewegungsrichtung nur mittels der Eigenspannung der Kontaktnadeln 11 zu bewegen, oder wenn anstelle der Feder 24 die Bewegung des Kolbens 23 in Richtung des Pfeiles B durch Einleiten von Druckmedium in den in diesem Ausführungsbeispiel von der Feder 24 besetzten Raum rechtsseitig des Kolbens 23 des Zylinders 22 bewirkbar oder steuerbar ist.

Es sind nun unterschiedliche Betriebsarten dieses Prüfadapters 10 möglich, was anhand von Kontaktierungen des Prüflinges 20 durch die Kontaktnadeln 11 nachfolgend beschrieben sei.

Bevor ein Prüfling durch die Kontaktnadeln 11 des Prüfadapters 10 kontaktiert wird, werden die Kontaktnadeln durch Bewegung der Spannplatte 14 in Richtung des Pfeiles A mittels des Stellmotors 21 voll gespannt, so daß sie die voll ausgezogen dargestellten gebogenen Stellungen einnehmen und nicht mehr, wie vor dem Spannen gerade sind. Sie sind dann voll gespannt, wenn die ihrem Spannen dienende Bewegung der Spannplatte 14 in Richtung des Pfeiles A beendet ist, und es findet dann kein stärkeres Ausbiegen der Kontaktnadeln 11 in dieser Ausbiegrichtung (Pfeil A) mehr statt. Durch dieses Spannen wandern die freien oder vorderen Enden 17 der Kontaktnadeln 11 in Richtung auf die Frontplatte 13 und damit auch auf die Spannplatte 14 zu, verringern also ihre Abstände von diesen Platten 13, 14, bspw. um 0,5 bis 3 mm oder je nach Sachlage auch um noch weniger oder noch mehr. Die Länge der Kontaktnadeln 11 kann bspw. 2 bis 20 cm betragen, je nach Sachlage auch noch weniger oder noch mehr.

Nach dem Spannen der Kontaktnadeln 11 wird der Prüfling 20 entweder durch Bewegung der ihn tragenden Aufspannplatte 40 oder durch Bewegen des Prüfadapters 10 mit seinen Pads 41 sehr nahe an die vorderen Enden 17 der Kontaktnadeln 11 gebracht oder bis zum Anliegen der Pads 41 an diesen vorderen Enden 17, wobei dieses Anliegen jedoch nur ohne Kraft oder nur mit viel geringerer Kraft erfolgt als zum Bewegen der freien Kontaktnadelenden 17 weiter nach oben nötig wäre. Der Prüfling 20 bewegt also die gespannten Kontaktnadeln 11 bezogen auf Fig.1 nicht nach oben, sondern verbleibt während des nachfolgenden Kontaktierens durch die Kontaktnadeln in konstantem Abstand von der Frontplatte 13. Oder es kann auch vorgesehen sein, daß zum besonders schonenden Kontaktieren des jeweiligen Prüflings 20 die diesen tragende Aufspannplatte 40 anstatt beim Kontaktieren des Prüflings durch die Kontaktnadeln 11 unbeweglich stehen zu bleiben, also in konstantem Abstand von der Frontplatte 13 - was an sich bevorzugt vorgesehen sein kann - sie geringfügig federnd angeordnet ist, derart, dass sie beim Kontaktieren eines von ihr getragenen Prüflings 20 geringfügig in von der Frontplatte 13 wegführender Richtung federnd nachgeben kann. Die Tragplatte 40 hat also ausser dem Halten des jeweiligen Prüflings die Aufgabe, den jeweiligen Prüfling 20, wenn er durch die Kontaktnadeln 11 kontaktiert wird, gegen die hierdurch auf ihn von den Kontaktnadeln 11 ausgeübten Kontaktkräfte unbeweglich oder ggfs. geringfügig federnd abzustützen, nicht aber die Aufgabe, die freien Enden 17 der Kontaktnadeln 11 auf die Frontplatte 13 zu zu bewegen, was letzteres so hohe Kräfte erfordern würde, wie sie bei der Erfindung gerade nicht nötig sind.

Die von den Kontaktnadeln 11 auf den jeweiligen Prüfling ausübbaren Kontaktkräfte können pro Kontaktnadel bspw. 30 bis 300 cN betragen.

Diese für sichere elektrische Kontaktierung der Pads 41 ausreichend großen axialen Kontaktkräfte der Kontaktnadeln 11 werden erst dann, nachdem der Prüfling 20 nach dem vollen Spannen der Kontaktnadeln 11 in die vorgesehene Stellung gegenüber der Frontplatte 13 gebracht ist, in der die Kontaktnadelenden 17 ihm in geringem Abstand gegenüberstehen oder ihn berühren oder mit nur geringer, sie nicht bewegender Kraft auf ihn drükken, dadurch bewirkt, indem das Ventil 33 so umgeschaltet wird, daß das vorangehend zum vollen Spannen der Kontaktnadeln 11 in den Arbeitsraum 32 eingeleitete Druckmedium aus ihm durch die Abflußleitung 35 hindurch wieder abfließen kann, was je nach Ausbildung des Drei-Wege-Ventiles 33 oder Einstellung eines in der Abflußleitung 35 angeordneten Drosselventils 47 rasch oder weniger rasch erfolgen kann. Die Kontaktnadeln drücken dann unter Mitwirkung der Rückstellfeder 24 die Spannplatte 14 nach links, und es gibt jetzt hier drei prinzipiell unterschiedliche Möglichkeiten, unterschiedlich große axiale Kontaktkräfte der Kontaktnadeln 11 auf den Prüfling 20 zu erzielen.

Diese drei prinzipiellen Möglichkeiten sind an Beispielen in den Fig. 2 bis 4 dargestellt.

Bei der in Fig. 2 dargestellten Möglichkeit wird die Spannplatte 14 zum Ausüben von ausreichend großen Kontaktkräften der Kontaktnadeln 11 auf die unbeweglich gehaltenen Pads 41 so weit nach links bewegt, bis sie auf die Biegenadeln bildenden Kontaktnadeln 11 keine Kräfte mehr ausübt, was in Fig. 2 dadurch gezeigt ist, indem die Kontaktnadel 11 sich im Abstand von der Wandung des über seine Länge konstanten Querschnitt aufweisenden Loches 16 befindet. Damit drückt die Kontaktnadel 11 nur unter Einwirkung ihrer eigenen, noch vorhandene Biegung auf den Prüfling 20, da dieser so relativ zum Gestell 42 des Prüfadapters angeordnet ist, daß, wenn die Kontaktnadel 11 durch die Spannplatte 14 wie dargestellt freigegeben ist, sie dann immer noch mehr oder weniger stark gebogen ist, derart, daß die gewünschte axiale Kontaktkraft auf den Prüfling 20 von ihr ausgeübt wird. In dem in Fig. 1 voll dargestellten gebogenen Zustand der Kontaktnadeln 11 ist ihre seitliche Ausbiegung größer als in Fig. 2.

Wenn gewünscht wird, daß die Kontaktnadeln 11 auf den Prüfling 20 axiale Kontaktkräfte ausüben, die größer sind als die durch die Kontaktnadeln in der in Fig. 2 dargestellten ausgeübten Stellung, wo sie von der Spannplatte 14 nicht mehr beeinflußt sind, also größere axiale Kontaktkräfte ausgeübt werden sollen, als die Kontaktnadeln 11 durch ihre Eigenelastizität als Biegenadeln ausüben würden, dann kann dies gemäß Fig. 3 dadurch erfolgen, indem der Stellmotor 21 - in diesem Ausführungsbeispiel seine Feder 24 - die Spannplatte 14 über ihren Stellungsbereich,in welchem sie keine Kräfte auf die Kontaktnadeln 11 mehr ausübt, noch weiter in Richtung des Pfeiles B bewegt, wodurch die von den Kontaktnadeln 11 auf den Prüfling 20 ausgeübten Kontaktkräfte über die in der Stellung der Spannplatte 14 gemäß Fig. 2 von den Kontaktnadeln 11 auf den Prüfling ausgeübten Kontaktkräfte hinaus in gewünschter Weise noch mehr oder weniger stark erhöht werden, wie es an einem Beispiel Fig. 3 zeigt. Dabei ist die auf die Spannplatte 14 von der Feder 24 in Richtung des Pfeiles B auszuübende Kraft viel geringer als der Summe der Erhöhungen der axialen Kontaktkräfte durch die Spannplatte 14 entspricht, wie man ohne weiteres erkennt. Hierbei kann vorgesehen sein, daß sich die Stellung der Spannplatte 14 nach Fig. 3 nur durch die Kraft der Feder 24 einstellt oder daß diese Stellung durch einen an der Kolbenstange 26 oder der Spannplatte 14 fest angeordneten Anschlag 45 begrenzt wird, indem dieser Anschlag 45 an ein vorzugsweise parallel zur Bewegungsrichtung der Spannplatte lageeinstellbares Widerlager 46 zur Anlage kommt, das seine Beweguung in Richtung des Pfeiles B begrenzt.

Man kann dieses Widerlager 46 auch so einstellen, daß es die Bewegung der Spannplatte 14 in Richtung des Pfeiles B in einer Stellung anhält, in der die Spannplatte 14 nicht mehr auf die Kontaktnadeln 11 drückt. Also bspw. kann dieser Anschlag 45 und das Widerlager 46 auch dazu dienen, die Spannplatte 14 in der in Fig. 2 oder auch in der in Fig 4 dargestellten Stellung anzuhalten.

Bei der in Fig. 4 dargestellten Möglichkeit der Betätigung des Prüfadapters 10 werden die von den Kontaktnadeln 11 auf den jeweiligen Prüfling 20 ausgeübten axialen Kontaktkräfte kleiner gehalten als wenn die Spannplatte 14 auf sie keine Kräfte mehr ausüben würde (Fig.2). Dies kann bspw. dadurch bewirkt werden, indem in diesem Ausführungsbeispiel das Widerlager 46 so eingestellt wird, daß die Spannplatte 14 aus ihrer dem vollen Spannen der Kontaktnadeln 11 dienenden äussersten rechten Stellung in Richtung des Pfeiles B nicht in eine Stellung bewegt werden kann, in der sie auf die Kontaktnadeln 11 keine Kräfte mehr ausübt, sondern sie bleibt auf ihrem zweiten Bewegungsweg in einer Stellung gehalten durch das Widerlager 46 stehen, in der die Kontaktnadeln 11 durch die Spannplatte 14 noch mehr oder weniger stark in Richtung des Pfeiles A belastet sind, so daß die volle Eigenelastizität der Kontaktnadeln 11 nicht zur Auswirkung kommt, sondern die Kontaktnadeln nur mit veringerten axialen Kontaktkräften, die durch unterschiedliche Einstellung des Widerlagers 46 beliebig eingestellt werden können, auf den Prüfling 20 drücken.

Nach erfolgter Prüfung eines Prüflinges 20 wird dieser durch Bewegen der Aufspannplatte 40 oder des Prüfadapters 10 vom Prüfadapter 10 wieder weggeführt und gegen einen neuen Prüfling 20 ausgewechselt. Bevor dieser neue Prüfling 20 in die vorgesehene Relativstellung zum Prüfadapter 10 gebracht wird, werden die Kontaktnadeln 11 wieder mittels der Spannplatte 14 durch deren Bewegen in Richtung des Pfeiles A voll gespannt, wozu der Arbeitsraum 32 mittels des Ventils 33 in leitende Verbindung mit dem Druckspeicher 27 gebracht wird, so daß das Druckmedium den Kolben 23 unter Mitnahme der Spannplatte 14 nach rechts bis in seine vorgesehene Endstellung bewegt, die durch einen nicht dargestellten, vorzugsweise einstellbaren Anschlag begrenzt sein kann oder durch den Druck des Druckmediums bestimmt sein kann. In dieser Endstellung der Spannplatte 14 sind die Kontaktnadeln 11 voll gespannt. Dann wird der Prüfling 20 in die vorgesehene Relativstellung zum Prüfadapter 10 gebracht und die Spannplatte 14 in Richtung des Pfeiles B wieder nach links bewegt und hierdurch die gewünschten axialen Kontaktkräfte von den Kontaktnadeln 11 auf die von ihnen kontaktierten Stellen des Prüflings 20 ausgeübt, so daß wiederum sicherer elektrischer Kontakt zwischen den von den Kontaktnadeln 11 kontaktierten Stellen des Prüflinges 20 und den Kontaktnadeln 11 erreicht wird und das Testgerät 19 die elektrische Prüfung dieses neuen Prüflinges auf elektrische Fehlerfreiheit durchführen kann.

Das Erreichen der gewünschten axialen Kontaktkräfte der Kontaktnadeln 11 auf den jeweiligen Prüfling 20 kann mittels des dargestellten Prüfadapters sanft und schonend oder ggf. rasch, gewünschtenfalls sogar praktisch schlagartig erfolgen, lediglich dadurch, indem man den Abfluß des Druckmediums aus dem Arbeitsraum 32 des Arbeitszylinders 22 langsam oder rasch erfolgen läßt. Hierzu ist in die Abflußleitung das Drosselventil 47 eingesetzt, das manuell in unterschiedliche Drosselstellungen einstellbar ist und den Abfluß des Druckmediums aus dem Arbeitsraum 32 also unterschiedlich rasch ermöglicht.

Der dargestellte Prüfadapter hat also zahlreiche Vorteile. Unter anderem benötigt er nur relativ wenig Kraft zum Spannen der Kontaktnadeln mit allen sich hieraus ergebenden Vorteilen. Auch läßt er langsames schonendes oder schnelles schlagartiges Kontaktieren der Prüflinge durch die Kontaktnadeln auf einfache Weise erreichen. Auch lassen sich die von den Kontaktnadeln auf die Prüflinge ausgeübten Kontaktkräfte in weiten Grenzen unterschiedlich einstellen, ohne daß es baulicher Änderungen des Prüfadapters 10 bedarf. Auch kann die Anzahl seiner Kontaktnadeln praktisch beliebig sein, bspw. kann er hunderte oder tausende oder noch mehr oder auch weniger Kontaktnadeln aufweisen.

## Ansprüche

1. Verfahren zum Kontaktieren von elektrischen oder elektronischen Prüflingen, wie Leiterplatten, integrierten Schaltkreisen, Chips oder dgl., mittels metallischen, federnd biegsamen Kontaktnadeln, die in einem Prüfadapter einer Prüfeinrichtung zum Prüfen solcher Prüflinge auf elektrische Fehlerfreiheit angeordnet sind und deren vorderen Enden dem Kontaktieren der Prüflinge dienen, wobei diese Kontaktnadeln in Löchern einer Frontplatte eines sie aufweisenden Prüfadapters axial beweglich geradegeführt sind und ferner mit mittleren Bereichen Löcher einer parallel zu sich selbst beweglichen Spannplatte durchdringen, die die Kontaktnadeln aus ihren geraden Stellungen seitlich ausbiegen kann, dadurch gekennzeichnet, daß die Kontaktnadeln durch die Spannplatte bis in ihre am weitesten ausgebogenen Stellungen gespannt werden, und daß die Kontaktnadeln auf den jeweils von ihnen kontaktierten Prüfling dadurch ansteigende Kräfte ausüben, indem der Prüfling gegen die von den Kontaktnadeln auf ihn ausübbaren Kräfte abgestützt und dabei nicht mehr auf die Spannplatte zu bewegt wird und die Spannplatte in einer Bewegungsrichtung (zweite Bewegungsrichtung) bewegt wird, die zu der dem Spannen der Kontaktnadeln dienenden Bewegungsrichtung (erste Bewegungsrichtung) entgegengesetzt ist.

2. Verfahren nach Anspruch 1, dadurch gekennzeichnet, daß der Prüfadapter mit durch die Spannplatte gespannten Kontaktnadeln und der Prüfling in eine Relativstellung zueinander gebracht werden, in der der Prüfling sich in geringem Abstand von den vorderen Enden der gespannten Kontaktnadeln befindet oder diese berührt und daß dann die Spannplatte durch Bewegen in ihrer zweiten Bewegungsrichtung in eine Stellung bewegt wird, in der die Kontaktnadeln den Prüfling mit den durch sie ohne Mitwirkung der Spannplatte bewirkbaren eigenen Federkräften kontaktieren.

3. Verfahren nach Anspruch 1, dadurch gekennzeichnet, daß der Prüfadapter mit durch die Spannplatte gespannten Kontaktnadeln und der Prüfling in eine Relativstellung zueinander gebracht werden, in der der Prüfling sich in geringem Abstand von den vorderen Enden der Kontaktnadeln befindet oder diese berührt und daß dann die Spannplatte in der zweiten Bewegungsrichtung bis in eine Stellung bewegt wird, in der die Kontaktnadeln Kräfte auf den Prüfling ausüben, die durch Andrücken der Spannplatte an die Kontaktstifte über die durch die Eigenfederung der Kontaktstifte bewirkbaren Kräfte hinaus noch vergrößert sind.

4. Verfahren nach Anspruch 1, dadurch gekennzeichnet daß der Prüfadapter mit durch die Spannplatte gespannten Kontaktnadeln und der Prüfling in eine Relativstellung zueinander gebracht werden, in der der Prüfling sich in geringem Abstand von den vorderen Enden der gespannten Kontaktnadeln befindet oder diese berührt und daß dann die Spannplatte durch Bewegen in ihrer zweiten Bewegungsrichtung in eine Stellung bewegt wird, bei der die Kontaktnadeln noch mit Vorspannung an der Spannplatte anliegen, derart, daß die Kräfte, die die Kontaktnadeln auf den Prüfling ausüben, kleiner sind als die Kräfte, die sie auf den Prüfling dann ausüben würden, wenn sie die Spannplatte nicht mehr berühren würden.

5. Verfahren nach einem der vorhergehenden Ansprüche, dadurch gekennzeichnet, daß der Abstand des Prüflings von der Spannplatte während der Vergrösserung der von den Kontaktnadeln auf den Prüfling durch Bewegen der Spannplatte in ihrer zweiten Bewegungsrichtung ausgeübten Kräfte konstant gehalten wird oder der Prüfling gegen die von den Kontaktnadeln auf ihn ausgeübten Kräfte federnd abgestützt ist.

6. Prüfadapter zur Durchführung des Verfahrens nach einem der vorhergehenden Ansprüche, dadurch gekennzeichnet, daß er eine Frontplatte (13) aufweist, die eine Mehrzahl von Löchern aufweist, in welchen vordere Bereiche der Kontaktnadeln (11) geradegeführt sind, wobei die vorderen Enden der Kontaktnadeln über diese Löcher überstehen können und/oder sich in ihnen befinden können, welche Kontaktnadeln mit mittleren Bereichen Löcher (16) einer Spannplatte (14) durchdringen, welche im Abstand von der Frontplatte parallel zu ihr angeordnet und quer zu den Längsachsen ihrer von den Kontaktnadeln durchdrungenen Löcher in einer zu ihrer ersten Bewegungsrichtung und in einer hierzu entgegengesetzten zweiten Bewegungsrichtung parallel zu sich selbst beweglich ist, daß die rückwärtigen Enden der Kontaktnadeln gegen axiales Verschieben zumindest in Rückwärtsrichtung gesichert sind, und daß Betätigungsmittel (22) zum zwangsweisen Bewegen der Spannplatte in ihrer ersten Bewegungsrichtung zum Spannen der Kontaktnadeln durch Biegen in ihre am weitesten ausgebogenen Stellungen vorgesehen sind, wobei dieses Spannen der Kontaktnadeln bewirkt, daß die freien Enden der Kontaktnadeln ihre Abstände von der Spannplatte verringern.

7. Prüfadapter nach Anspruch 6, dadurch gekennzeichnet, daß auch Betätigungsmittel (24) zum zwangsweisen Bewegen der Spannplatte (14) in deren zweiten Bewegungsrichtung vorgesehen sind.

8. Prüfadapter nach Anspruch 6 oder 7, dadurch gekennzeichnet, daß das Betätigungsmittel oder mindestens ein Betätigungsmittel mindestens einen Stellmotor (21) aufweist.

9. Prüfadapter nach einem der Ansprüche 6 bis 8, dadurch gekennzeichnet, daß die Spannplatte (14) mittels eines Getriebes mit einem durch eine Bedienungsperson bewegbaren Betätigungsorgan zu ihrem Verschieben in mindestens einer ihrer Bewegungsrichtungen verbunden ist.

10. Prüfadapter nach einem der Ansprüche 7 bis 9, dadurch gekennzeichnet, daß die Betätigungsmittel (24) zum zwangsweisen Bewegen der Spannplatte (14) in ihrer zweiten Bewegungsrichtung über die Stellung hinaus, in der sie die Kontaktnadeln nicht belastet, zur Vergrößerung der von den Kontaktnadeln auf Prüflinge (20) ausübbaren Kräfte ausgebildet sind.

11. Prüfadapter nach einem der Ansprüche 6 bis 10, dadurch gekennzeichnet, daß die parallel zur ersten und zweiten Bewegungsrichtung der Spannplatte (14) gemessene minimale Breite der von den Kontaktnadeln (11) durchdrungenen Löchern (16) der Spannplatte mindestens dem 1,5-fachen Durchmesser, vorzugsweise mindestens dem 3-fachen Durchmesser der Kontaktnadeln (11) im Bereich dieser Löcher (16) entspricht.

FIG.1

FIG.2

FIG.3

FIG4